# EUROPÄISCHE PATENTSCHRIFT

(11) **EP 1 979 755 B1**
(45) Veröffentlichungstag und Bekanntmachung des Hinweises auf die Patenterteilung: **25.10.2017**
(21) Anmeldenummer: 07703208.4
(22) Anmeldetag: 01.02.2007
(51) Int. Cl.: G01R 23/14, G01R 27/32, H01P 5/12

(54) **NETZWERKANALYSATOR MIT SCHALTBARER MESSBRÜCKE**
NETWORK ANALYZER COMPRISING A SWITCHABLE MEASURING BRIDGE
ANALYSEUR DE RÉSEAU DOTÉ D'UN PONT DE MESURE COMMUTABLE

(30) Priorität: 03.02.2006 DE 102006005040
(43) Veröffentlichungstag der Anmeldung: 15.10.2008
(73) Patentinhaber: Rohde & Schwarz GmbH & Co. KG, 81671 München (DE)
(72) Erfinder: HELD, Werner, 94060 Pocking (DE)
(74) Vertreter: Körfer, Thomas
(86) Internationale Anmeldenummer: PCT/EP2007/000879
(87) Internationale Veröffentlichungsnummer: WO 2007/090564

(56) Entgegenhaltungen:
- DE-A1- 10 246 700
- US-A1- 2006 001 505
- US-A1- 2006 197 626
- US-B1- 7 019 510

## Beschreibung

Die Erfindung bezieht sich auf einen Netzwerkanalysator zur Analyse eines an diesem anschließbaren Meßobjekts.

Zur Analyse eines Meßobjekts wird von einem Netzwerkanalysator ein Anregungssignal zur Verfügung gestellt. Das Anregungssignal wird über Tore des Meßobjekts diesem zugeführt. Beispielsweise wird zur Ermittlung eines Eingangsreflexionsfaktors und eines Vorwärtsübertragungsfaktors sowie eines Ausgangsreflexionsfaktors und eines Rückwärtsübertragungsfaktors das Anregungssignal dem Meßobjekt, welches ein Eingangstor und ein Ausgangstor aufweist, über das Eingangstor oder über das Ausgangstor zugeführt. Zur Ermittlung der Reflexionsfaktoren und der Übertragungsfaktoren ist am Eingangs- und/oder Ausgangstor des Meßobjekts jeweils die einfallende als auch die rücklaufende Welle des Anregungssignals zu erfassen. Um zu ermitteln, bei welchem Frequenzbereich das Anregungssignal das Meßobjekt passiert und bei welchem Frequenzbereich das Anregungssignal am Eingangs- und/oder Ausgangstor des Meßobjekts reflektiert wird, fährt der Netzwerkanalysator in einem Frequenz-Sweep die Frequenz des Anregungssignals durch einen vorgegebenen Frequenzbereich.

Ein Netzwerkanalysator dieser Art ist beispielsweise aus der Druckschrift DE 102 46 700 A1 bekannt.

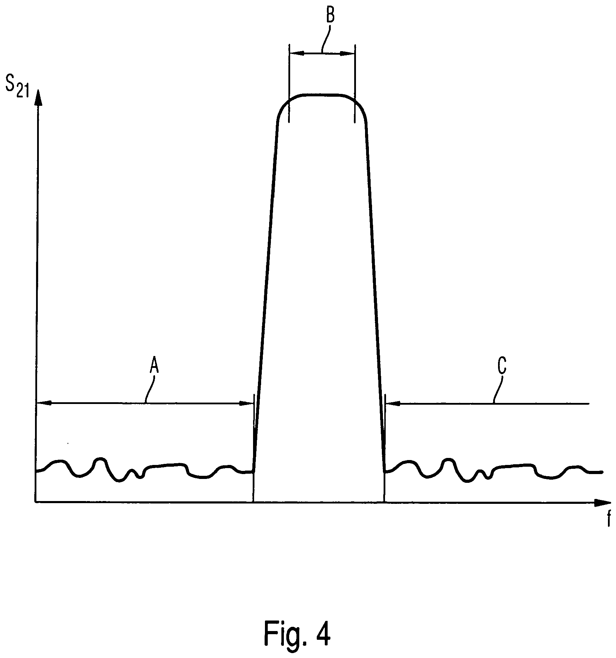

In Fig. 4 ist der Torparameter "Vorwärtsübertragungsfaktor s₂₁" eines als Bandpaß ausgeführten Meßobjekts über die Frequenz gezeigt. Der Torparameter s₂₁ beschreibt das Verhältnis der durch das Meßobjekt transmittierten und am Ausgangstor des Meßobjekts rücklaufenden Welle b₂ zu der am Eingangstor einfallenden Welle a₁ des Anregungssignals. Das Anregungssignal wird am Eingangstor des Bandpasses im Frequenzbereich A sowie im Frequenzbereich C reflektiert. Im Frequenzbereich B transmittiert des Anregungssignal durch den Bandpaß.

Bei einem gewöhnlichen Netzwerkanalysator ist ein Übergang zwischen den im Weiteren als Sperrbereich bezeichneten Frequenzbereichen A und C in den im Weiteren als Durchlaßbereich bezeichneten Frequenzbereich B vergleichsweise ungenau meßbar. Außerdem ist der Frequenzbereich, bei welchem der jeweilige Übergang erfolgt, lediglich ungenau bestimmbar. Ferner ist es bei einem derartigen Netzwerkanalysator nicht ohne weiteres möglich, das Meßobjekt über einen vergleichsweise großen Frequenzbereich von besonders tiefen bis zu besonders hohen Frequenzen zu analysieren.

Dies liegt zum einen daran, dass zwar ein bestimmter Frequenzbereich von dem Netzwerkanalysator durchgefahren (Sweep) wird. Jedoch ist die Auskopplung von einem Referenzsignal, welches dem Anregungssignal entspricht, und von einem Meßsignal, welches einem vom Meßobjekt rücklaufenden Signal entspricht, an einer am Netzwerkanalysator vorgesehenen, als resistive Brücke ausgebildete Meßbrücke zur Analyse des am Eingangstor oder am Ausgangstor des Meßobjekts reflektierten oder durch das Meßobjekt transmittierten Anregungssignals insbesondere bei vergleichsweise hohen Frequenzen durch an der Meßbrücke auftretende parasitäre Elemente, wodurch sich Störeinwirkungen an den ausgekoppelten Signalen bemerkbar machen, problematisch.

Dies liegt zum anderen daran, dass die in der als Richtkoppler ausgebildeten Meßbrücke vorgesehenen Kopplungsstrecken lediglich für einen bestimmten Frequenzbereich konzipiert sind. Beispielsweise sind für die Auskopplung eines Referenz- und/oder Meßsignals mit einem Anregungssignal von vergleichsweise tiefer Frequenz besonders lange Kopplungsstrecken erforderlich, welche lediglich mit unverhältnismäßig hohem technischen Aufwand realisierbar sind.

Bei der Analyse des Meßobjekts stößt der gewöhnliche Netzwerkanalysator somit schnell an seine Grenzen, da das Referenzsignal und das Meßsignal bei vergleichsweise tiefen und hohen Frequenzen aufgrund besonders starker Abschwächung des Anregungssignals bzw. des rücklaufenden Signals bei der Auskopplung an der Meßbrücke lediglich mit besonders niedriger Qualität ausgekoppelbar sind. Infolgedessen ist beispielsweise auch der prozentuale Anteil des am Meßobjekt reflektierten Anregungssignals oder des durch das Meßobjekt transmittierten Anregungssignals bei hohen oder tiefen Frequenzen nur ungenau bestimmbar. Die Dynamik eines derartigen Netzwerkanalysators, worunter das Verhältnis von minimal zu maximal meßbarer Transmission zu verstehen ist, ist also bei hohen und tiefen Frequenzen vergleichsweise klein. Die Druckschrift US2006/001505A1 offenbart einen Netzwerkanalysator mit einer parallelen Anordnung eines Richtkopplers und einer Reflexionsmessbrücke, die abhängig von der Arbeitsfrequenz durch eine Schaltanordnung ausgewählt werden. Diese Struktur bringt jedoch mit sich erhebliche Probleme in der Dynamik. Der Erfindung liegt die Aufgabe zu Grunde, einen Netzwerkanalysator zur Analyse eines an diesem anschließbaren Meßobjekts besonders kostengünstig zur Verfügung zu stellen, womit der zur besonders exakten Analyse des Meßobjekts erforderliche Frequenzbereich über die Breite des vom Netzwerkanalysator zur Verfügung gestellten Frequenzbereichs in vollem Umfang auswertbar und die Dynamik des Netzwerkanalysators erweitert wird.

Bezüglich des Netzwerkanalysators wird die Aufgabe gelöst durch die Merkmale des Anspruchs 1. Vorteilhafte Weiterbildungen sind Gegenstand der hierauf rückbezogenen Unteransprüche.

So umfasst der erfindungsgemäße Netzwerkanalysator einen Signalgenerator, womit ein Anregungssignal zur Analyse eines am Netzwerkanalysator anschließbaren Meßobjekts erzeugbar und über eine Meßleitung diesem zuführbar ist, sowie eine an der Meßleitung angeordnete Meßbrücke, worüber ein dem Anregungssignal entsprechendes Referenzsignal auf einen Referenzkanal und ein einem auf der Meßleitung vom Meßobjekt rücklaufenden Signal entsprechendes Meßsignal auf einen Meßkanal auskoppelbar sind. Weiterhin weist die Meßbrücke des Netzwerkanalysators eine resistive Brücke und einen Richtkoppler auf, welcher zu der resistiven Brücke in Serie geschaltet ist. Gegebenenfalls sind mehrere Richtkoppler zur resistiven Brücke in Serie schaltbar. Im Weiteren ist die Meßbrücke derart ausgebildet, dass das Referenzsignal und das Meßsignal in einem unteren Frequenzbereich von der resistiven Brücke und in einem oberen Frequenzbereich von dem Richtkoppler auf den Referenzkanal bzw. den Meßkanal auskoppelbar sind.

Der Richtkoppler sowie die resistive Brücke koppeln einen Teil der auf der Meßleitung laufenden Leistung aus und trennen dabei die ausgekoppelte Leistung der vorlaufenden Welle des Anregungssignals von der ausgekoppelten Leistung der rücklaufenden Welle des rücklaufenden Signals.

Das Meßobjekt kann ein Vielpol mit einem oder mehreren Eingangstoren und einem oder mehreren Ausgangstoren sein. Zur Analyse des Vielpols ist dieser sowohl über das Eingangstor als auch über das Ausgangstor mit der Meßleitung des Netzwerkanalysators signalverbindbar. Das bedeutet, dass das Anregungssignal am Eingangstor sowie am Ausgangstor dem Meßobjekt zuführbar ist.

Der vom Signalgenerator des Netzwerkanalysators durchfahrene (Sweep) Frequenzbereich zur Analyse des Meßobjekts ist in den oberen und den unteren Frequenzbereich aufteilbar. Die Meßbrücke ist im unteren Frequenzbereich als resistive Brücke betrieben. Ab einer bestimmten maximalen Grenzfrequenz machen sich parasitäre Elemente des Übertragers und der Widerstände der resistiven Brücke störeinwirkend bei der Auskopplung des Anregungssignals und/oder des rücklaufenden Signals bemerkbar. Deshalb ist die Meßbrücke oberhalb der maximalen Grenzfrequenz im oberen Frequenzbereich als Richtkoppler betrieben. Dabei ist der Richtkoppler ausgebildet, den oberen Frequenzbereich abzudecken. Für die Auskopplung des Anregungssignals und/oder des rücklaufenden Signals unterhalb einer minimalen Grenzfrequenz würde die Realisierung des Richtkopplers einen erheblichen technischen Aufwand und unverhältnismäßig hohe Kosten verursachen, da beispielsweise Kopplungsstrecken des Richtkopplers zur Auskopplung des Anregungssignals und/oder des rücklaufenden Signals unterhalb der minimalen Grenzfrequenz eine vergleichsweise große Länge aufweisen würden. Dadurch würden sich wiederum die Ausmaße des Richtkopplers, der Meßbrücke und letzten Endes des Netzwerkanalysators erheblich vergrößern.

Zumeist fällt die maximale Grenzfrequenz der resistiven Brücke nicht mit der minimalen Grenzfrequenz des Richtkopplers zusammen. Dadurch definieren die minimale Grenzfrequenz und die maximale Grenzfrequenz einen zwischen diesen liegenden Grenzfrequenzbereich, welcher eine Schnittmenge der oberen und unteren Frequenzbereiche darstellt. In dem Grenzfrequenzbereich ist die Meßbrücke als resistive Brücke sowie als Richtkoppler betreibbar.

Gemäß vorteilhafter Weiterbildung umfasst die Meßbrücke Wechselschalter, welche vorgesehen sind, um zwischen dem Betrieb der Meßbrücke als resistive Brücke und dem Betrieb der Meßbrücke als Richtkoppler zu wechseln. Ist die Meßbrücke als resistive Brücke oder als Richtkoppler betrieben, ist das dem Anregungssignal entsprechende Referenzsignal am Referenzzweig der resistiven Brücke bzw. des Richtkopplers auskoppelbar und dem Referenzkanal der Meßbrücke zuführbar. Das auf der Meßleitung rücklaufende Signal, welches einem am Eingangs- oder Ausgangstor des Meßobjekts reflektierten oder einem durch das Meßobjekt transmittierten Anregungssignal entspricht, ist als Meßsignal am Meßzweig der resistiven Brücke bzw. des Richtkopplers auskoppelbar. Das ausgekoppelte Meßsignal ist über den Meßzweig der resistiven Brücke bzw. des Richtkopplers dem Meßkanal der Meßbrücke zuführbar. Dazu sind die Referenzzweige der resistiven Brücke sowie des Richtkopplers und die Meßzweige der resistiven Brücke sowie des Richtkopplers mit dem Referenzkanal bzw. dem Meßkanal der Meßbrücke signalverbindbar.

Zweckmäßigerweise sind an der Meßbrücke ein signalgeneratorseitiger und ein erster meßobjektseitiger Wechselschalter vorgesehen, wozwischen die resistive Brücke und der Richtkoppler ausgebildet sind. Im Betrieb der Meßbrücke als Richtkoppler sind der signalgeneratorseitige und der erste meßobjektseitige Wechselschalter derart geschaltet, dass das auf der Meßleitung zum Meßobjekt vorlaufende Anregungssignal einen Durchgangszweig des Richtkopplers passiert, welcher eine vergleichsweise geringe Dämpfung aufweist, sowie den signalgeneratorseitigen und den ersten meßobjektseitigen Wechselschalter passiert und nahezu ungedämpft zum Meßobjekt gelangt.

Um das rücklaufende Signal nahezu ungedämpft als Meßsignal an der Meßleitung des Netzwerkanalysators auszukoppeln, ist der als Koppelpfad ausgeführte Meßzweig des Richtkopplers in Bezug auf die Meßleitung des Richtkopplers geeignet zu positionieren. Dazu ist der Meßzweig des Richtkopplers dem ersten meßobjektseitigen Wechselschalter hinsichtlich einer Laufrichtung derart vorgeschaltet, dass das von dem Meßobjekt auf der Meßleitung rücklaufende Signal zunächst ein Wegstück der Meßleitung passiert, welches in unmittelbarer Nähe zum Meßzweig des Richtkopplers verläuft, und darauffolgend den meßobjektseitigen Wechselschalter erreicht. Damit ist unter der Laufrichtung des rücklaufenden Signals eine Richtung mit einem Richtungspfeil definiert, dessen Startpunkt am Meßobjekt positioniert ist und dessen Pfeilspitze in Richtung des Signalgenerators zeigt.

Ist die Meßbrücke im Gegensatz dazu als resistive Brücke betrieben, passiert das vom Meßobjekt rücklaufende Signal den ersten meßobjektseitigen Wechselschalter und wird mittels eines an der resistiven Brücke vorgesehenen Übertragers auf einen Meßzweig der resistiven Brücke ausgekoppelt.

Gemäß eines vorteilhaften Ausgestaltung ist der Richtkoppler und die resistive Brücke derart in der Meßbrücke realisiert, dass der Referenzzweig des Richtkopplers und der Referenzzweig der resistiven Brücke in einem gemeinsamen Zweig ausgebildet sind.

Um das ausgekoppelte Meßsignal im Betrieb der Meßbrücke als Richtkoppler sowie im Betrieb der Meßbrücke als resistive Brücke dem Meßkanal der Meßbrücke zuzuführen, ist in zweckmäßiger Weiterbildung ein erster meßkanalseitiger Wechselschalter am Meßkanal der Meßbrücke vorgesehen. Der erste meßkanalseitige Wechselschalter ist je nach Betrieb der Meßbrücke als Richtkoppler oder als resistive Brücke entsprechend auf den Meßzweig des Richtkopplers bzw. auf den Meßzweig der resistiven Brücke geschaltet.

Um die Auskopplung des Meßsignals hinsichtlich der Dämpfung durch für die Auskopplung erforderlichen Bauelemente, wie beispielsweise Wechselschalter, dem Übertrager der resistiven Brücke und dem Koppelpfad des Richtkopplers, besonders zu verbessern, ist es von Vorteil, einen zweiten meßobjektseitigen Wechselschalter an der Meßbrücke vorzusehen. Mittels des zweiten meßobjektseitigen Wechselschalters ist ein Durchgangspfad ausbildbar, wodurch die Meßleitung des Netzwerkanalysators mit dem Meßkanal der Meßbrücke leitungsverbindbar ist. Damit kann das rücklaufende Signal leitungsgebunden vom Meßobjekt in den Meßkanal der Meßbrücke weitergeleitet werden. Ein derartiger Durchgangspfad weist eine vergleichsweise geringe Dämpfung auf. Ebenso wie im Durchgangspfad zwischen dem signalgeneratorseitigen und dem ersten meßobjektseitigen Wechselschalter, wird das rücklaufende Signal demzufolge nahezu nicht abgeschwächt, da es lediglich den zweiten meßobjektseitigen Wechselschalter sowie einen zweiten meßkanalseitigen Wechselschalter passiert, welcher zwischen dem Meßzweig des Richtkopplers bzw. dem Meßzweig der resistiven Brücke und dem Durchgangspfad umschaltet.

Der zweite meßkanalseitige Wechselschalter ist zweckmäßigerweise dem ersten meßkanalseitigen Wechselschalter nachgeschaltet, um einen dritten Wechselschalter im Durchgangspfad zu vermeiden. Weiterhin ist es zweckmäßig, den zweiten meßobjektseitigen Wechselschalter dem ersten meßobjektseitigen Wechselschalter hinsichtlich der Laufrichtung des rücklaufenden Signals vorzuschalten, da dann das rücklaufende Signal den ersten meßobjektseitigen Wechselschalter nicht passiert, sondern direkt dem Meßkanal zuführbar ist.

In zweckmäßiger Weiterbildung sind die an den Meßbrücke vorgesehenen Wechselschalter als elektromechanische Schalter ausgebildet. Die elektromechanischen Schalter sind dabei derart ausgebildet, dass während des Durchfahrens des Frequenzbereichs durch den Signalgenerator zur Analyse des Meßobjekts ein Durchschreiten einer Umschaltfrequenz im genannten Grenzfrequenzbereich durch den signalgeneratorseitigen, den ersten meßobjektseitigen und den ersten meßkanalseitigen Wechselschalter erfaßt wird und ein Umschalten zwischen dem Betrieb der Meßbrücke als Richtkoppler oder als resistive Brücke in den Betrieb der Meßbrücke als resistive Brücke bzw. als Richtkoppler mit denselben Wechselschaltern durchgeführt wird.

Die mit der Erfindung erzielten Vorteile bestehen insbesondere darin, dass das dem Meßobjekt zuzuführende Anregungssignal, welches die Meßbrücke auf dem Weg zum Meßobjekt entlang deren Durchgangspfad passiert, an der Meßbrücke des erfindungsgemäßen Netzwerkanalysators eine besonders geringe Dämpfung erfährt. Damit ist also die Einfügedämpfung der Meßbrücke besonders gering.

Des Weiteren ist der erfindungsgemäße Netzwerkanalysator zur Analyse des Meßobjekts über einen vorgegebenen Frequenzbereich von besonders tiefen zu besonders hohen Frequenzen nutzbar.

Ferner ist die Verwendung des Durchgangspfads zur Weiterleitung des rücklaufenden Signals zum Meßkanal der Meßbrücke über den gesamten vom Signalgenerator zu durchfahrenden Frequenzbereich insbesondere dann von Vorteil, wenn die Meßbrücke ein durch das Meßobjekt transmittiertes Anregungssignal als rücklaufendes Signal empfängt. Für diesen Fall arbeitet die Meßbrücke als so genanntes Transmissionsmeßwerk. Im Gegensatz dazu arbeitet die Meßbrücke als Reflexionsmeßwerk, wenn die Meßbrücke ein am Meßobjekt reflektiertes Anregungssignal als rücklaufendes Signal empfängt.

Zudem ist die Meßbrücke derart ausgebildet, dass zu der Serienschaltung der resistiven Brücke und des Richtkopplers weitere Richtkoppler in Serie geschaltet werden können.

Außerdem ist die Meßbrücke schaltungstechnisch derart ausgebildet, dass im Betrieb der Meßbrücke als Transmissionsmeßwerk ein Durchgangspfad mit besonders geringer Dämpfung zwischen der Meßleitung des Netzwerkanalysators und dem Meßkanal der Meßbrücke geschaltet werden kann, wobei der Durchgangspfad statt eines Koppelpfads zur Weiterleitung des rücklaufenden Signals auf den Meßkanal der Meßbrücke verwendbar ist.

Darüber hinaus ist die Meßbrücke des erfindungsgemäßen Netzwerkanalysators besonders kostengünstig aufgebaut, da der Referenzzweig des Richtkopplers und der Referenzzweig der resistiven Brücke schaltungstechnisch zumindest teilweise zu einem Referenzzweig zusammengelegt ist.

Im weiteren sind die in der Meßbrücke vorgesehenen Wechselschalter als elektromechanische Schalter ausgebildet, welche bei Durchschreiten der Umschaltfrequenz die als Richtkoppler oder als resistive Brücke betriebene Meßbrücke in den Betrieb als resistive Brücke bzw. als Richtkoppler umschalten.

Nachfolgend werden Ausführungsbeispiele der Erfindung anhand einer Zeichnung näher erläutert. Darin zeigen:
- Fig. 1: ein Prinzipschaltbild eines Netzwerkanalysators mit einem an diesem angeschlossenen Meßobjekt und mit Meßbrücken,
- Fig. 2: ein Schaltbild eines ersten Ausführungsbeispiels einer Meßbrücke des erfindungsgemäßen Netzwerkanalysators mit einer resistiven Brücke und einem zu dieser in Serie geschalteten Richtkoppler,
- Fig. 3: ein Schaltbild eines zweiten Ausführungsbeispiels einer Meßbrücke des erfindungsgemäßen Netzwerkanalysators mit einer resistiven Brücke und einem zu dieser in Serie geschalteten Richtkoppler und
- Fig. 4: einen Verlauf des Vorwärtsübertragungsfaktors s₂₁ eines als Bandpaß ausgeführten Meßobjekts über der Frequenz.

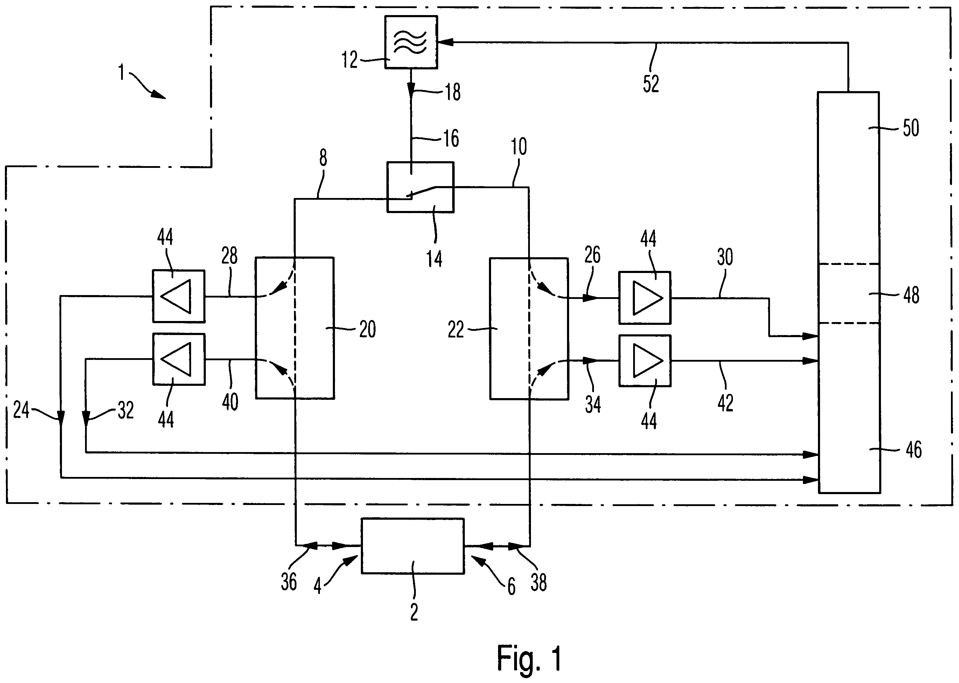

In Fig. 1 ist der Übersicht halber ein Prinzipschaltbild eines Netzwerkanalysators 1 gezeigt. An dem Netzwerkanalysator 1 ist ein Meßobjekt 2 mit einem Eingangstor 4 und einem Ausgangstor 6 über Meßleitungen 8 und 10 angeschlossen. Der Netzwerkanalysator 1 umfasst weiter einen Signalgenerator 12 sowie eine beispielsweise als elektromechanischer Schalter ausgebildete Schaltereinrichtung 14, worüber ein vom Signalgenerator 12 erzeugtes und auf der Signalleitung 16 zur Verfügung gestelltes, vorlaufendes Anregungssignal 18 auf die zum Eingangstor 4 führende Meßleitung 8 oder auf die zum Ausgangstor 6 führende Meßleitung 10 weitergeleitet ist.

Der Netzwerkanalysator 1 weist außerdem an den Meßleitungen 8 und 10 angeordnete Meßbrücken 20 bzw. 22 auf. Die Meßbrücke 20 unterscheidet sich lediglich dadurch von der Meßbrücke 22, dass die Meßbrücke 20 an den Meßleitung 8 angeordnet ist, welche mit dem Eingangstor 4 des Meßobjekts 2 verbunden ist. Im Gegensatz dazu ist die Meßbrücke 22 an den Meßleitung 10 angeordnet, welche mit dem Ausgangstor 6 des Meßobjekts 2 verbunden ist. Über jeweils eine Meßbrücke 20,22 wird ein Referenzsignal 24,26, welches dem Anregungssignal 18 entspricht, auf jeweils einen Referenzkanal 28,30 und ein Meßsignal 32,34, welches einem vom Meßobjekt 2 rücklaufenden Signal 36,38 entspricht, auf einen Meßkanal 40,42 ausgekoppelt. Der Referenzkanal 28,30 und der Meßkanal 40,42 weisen jeweils einen Verstärker 44 auf, welcher das Referenzsignal 24,26 und das Meßsignal 32,34 verstärkt. Des Weiteren sind der Referenzkanal 28,30 und der Meßkanal 40,42 mit einem A/D-Wandler (Analog/Digital-Wandler) 46 signalverbunden, welchem das ausgekoppelte Referenzsignal 24,26 und das ausgekoppelte Meßsignal 32,34 zugeführt werden.

Der A/D-Wandler 46 ist auch mit einer Auswerteeinrichtung 48 signalverbunden, welche das Referenzsignal 24,26 und das Meßsignal 32,34 analysiert. Im Weiteren ist die Auswerteeinrichtung 48 mit einer Steuereinrichtung 50 signalverbunden, welche den Signalgenerator 12 über eine Steuersignalleitung 52 ansteuert. Der Signalgenerator 12 wird über die Steuersignalleitung 52 von der Steuereinrichtung 50 zur Erzeugung des Anregungssignals 18 mit einer vorgegebenen Frequenz zur Analyse des Meßobjekt 2 angesteuert. Gegebenenfalls erfolgt eine Analyse des Meßobjekt 2 für mehrere Frequenzen in einem vorgegebenen Frequenzbereich. Für diesen Fall veranlaßt die Steuereinrichtung 50 den Signalgenerator 12, den Frequenzbereich zu durchfahren (Sweep).

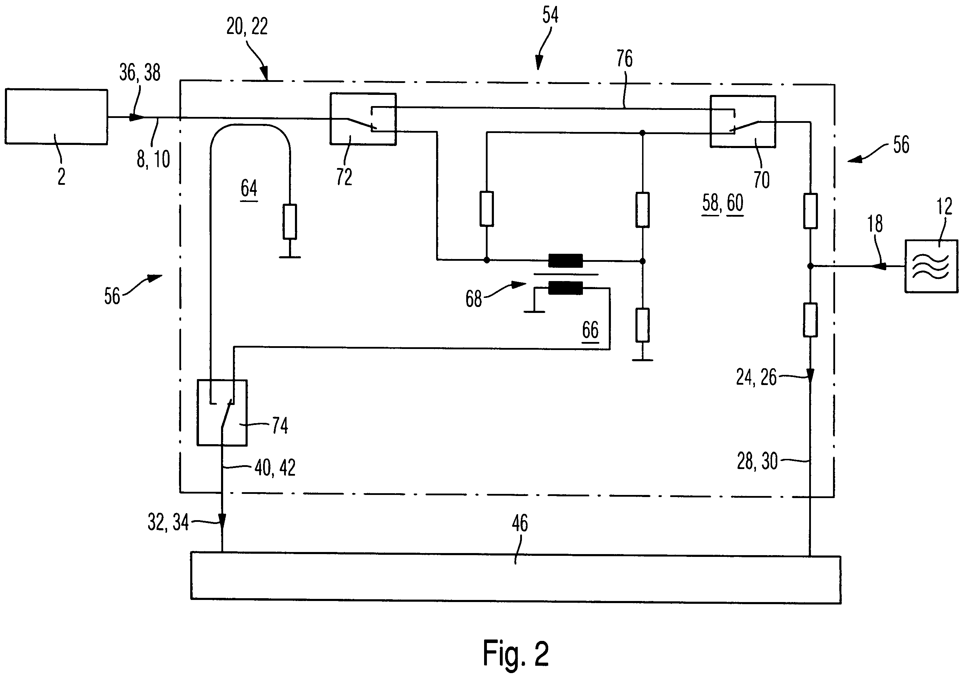

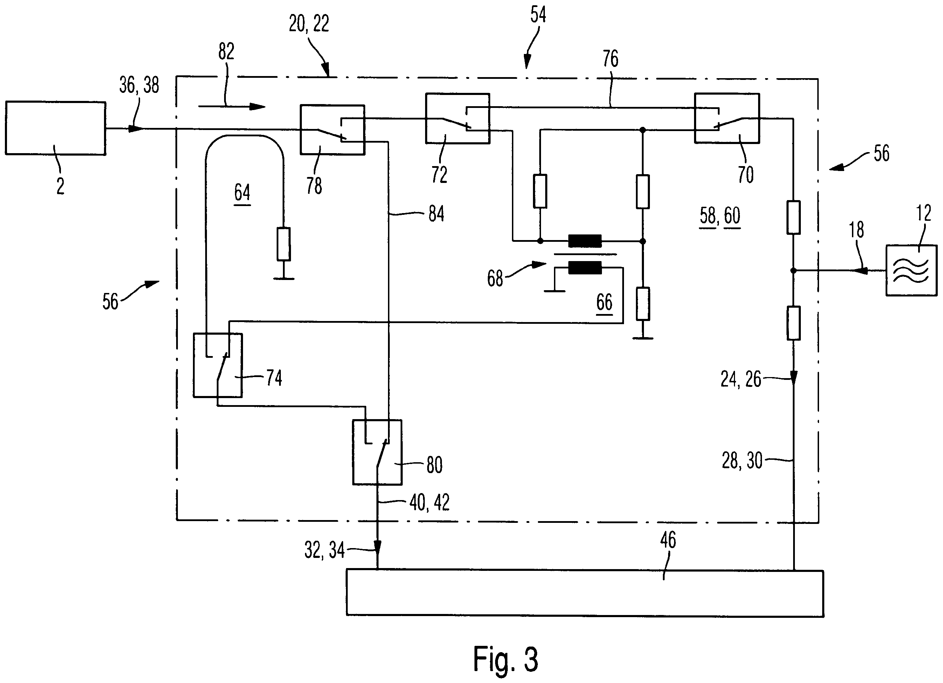

Die Figuren 2 und 3 zeigen ein detailliertes Schaltbild der Meßbrücke 20,22 des Netzwerkanalysators 1. Der Einfachheit halber ist die Schaltereinrichtung 14 weggelassen und die Meßbrücke 20,22 unmittelbar über den Meßleitung 8,10 an den Signalgenerator 12 angeschlossen. Ferner wird in Fig. 2 und 3 darauf verzichtet, die Auswerteeinrichtung 48 und die Steuereinrichtung 50 zu zeigen. Die Meßbrücke 20,22 ist weiterhin über den Meßleitung 8,10 an das Meßobjekt 2 angeschlossen. Der Referenzkanal 28,30 und der Meßkanal 40,42 ist mit dem A/D-Wandler 46 signalverbunden.

Die in den Figuren 2 und 3 gezeigte Meßbrücke 20,22 umfasst weiterhin eine resistive Brücke 54 und einen zu dieser in Serie geschalteten Richtkoppler 56. Die resistive Brücke 54 und der Richtkoppler 56 weisen jeweils einen Referenzzweig 58 und 60 zur Auskopplung des dem Anregungssignal 18 entsprechenden Referenzsignals 24,26 auf. Zur Auskopplung des entsprechenden Meßsignals 32,34, welches dem auf der Meßleitung 8,10 rücklaufenden Signal 36,38 entspricht, umfasst der Richtkoppler 56 einen als Koppelpfad ausgebildeten Meßzweig 64. Die resistive Brücke 54 weist zur Auskopplung des rücklaufenden Signals 36,38 als Meßsignal 32,34 einen Meßzweig 66 auf. Bei der resistiven Brücke 54 wird das Meßsignal 32,34 mittels eines Übertragers 68 auf den Meßzweig 66 ausgekoppelt.

Zum Umschalten zwischen dem Richtkoppler 56 und der resistiven Brücke 54 umfasst die Meßbrücke 20,22 einen signalgeneratorseitigen Wechselschalter 70 sowie einen ersten meßobjektseitigen Wechselschalter 72. Im Betrieb der Meßbrücke 20,22 als resistive Brücke 54 sind der signalgeneratorseitige Wechselschalter 70 und der erste meßobjektseitigen Wechselschalter 72, wie in Fig. 2 und 3 symbolisch gezeigt, nach unten geschaltet. Im Gegensatz dazu sind der signalgeneratorseitige Wechselschalter 70 und der erste meßobjektseitigen Wechselschalter 72 im Betrieb der Meßbrücke 20,22 als Richtkoppler 56 nach oben geschaltet.

Des Weiteren umfasst die Meßbrücke 20,22 einen ersten meßkanalseitigen Wechselschalter 74, um im Betrieb der Meßbrücke 20,22 als Richtkoppler 56 das ausgekoppelte Meßsignal 32,34 vom Meßzweig 64 des Richtkopplers 56 in den Meßkanal 40,42 der Meßbrücke 20,22 weiterzuleiten. Für den Betrieb der Meßbrücke 20,22 als resistive Brücke 54 ist der erste meßkanalseitige Wechselschalter 74 umschaltbar, um den Meßzweig 66 der resistiven Brücke 64 mit dem Meßkanal 40,42 der Meßbrücke 20,22 zu verbinden.

Das Anregungssignal 18 passiert im Betrieb der Meßbrücke 20,22 als Richtkoppler 56 einen Durchgangszweigs 76 des Richtkopplers 56 mit vergleichsweise geringer Dämpfung. Der Durchgangspfad 76 des Richtkopplers 56 ist über den gesamten vom Signalgenerator 12 zu durchfahrenden (Sweep) Frequenzbereich verwendbar. Das Anregungssignal 18 wird am Referenzzweig 58 als Referenzsignal 64 ausgekoppelt und dem Referenzkanal 28,30 der Meßbrücke 20,22 zugeführt. Das durch das Meßobjekt 2 transmittierte oder am Eingangstor 4 oder am Ausgangstor 6 des Meßobjekts 2 reflektierte, rücklaufende Signal 36,38 wird als Meßsignal 32,34 über den Meßzweig 64 des Richtkopplers 56 ausgekoppelt.

Zweckmäßigerweise ist der als Koppelpfad ausgebildete Meßzweig 64 in unmittelbarer Nähe der Meßleitung 8,10 derart positioniert, dass das rücklaufende Signal 36,38 zunächst ein Wegstück der Meßleitung 8,10 in unmittelbarer Nähe zum Meßzweig 64 passiert, bevor es den ersten meßobjektseitigen Wechselschalter 72 erreicht. Würde im Gegensatz dazu das rücklaufende Signal 36,38 nach dem ersten meßobjektseitigen Wechselschalter 72 am Meßzweig 64 ausgekoppelt werden, wäre es von der Dämpfung des ersten meßobjektseitigen Wechselschalter 72 abgeschwächt. Der Richtkoppler 56 ist für den Betrieb der Meßbrücke 20,22 in einem oberen Frequenzbereich vorgesehen, worin ein Betrieb der Meßbrücke 20,22 als resistive Brücke 54 ungeeignet wäre. Der Übertrager 68 der resistiven Brücke 54 weist parasitäre Elemente auf, welche sich bei vergleichsweise hohen Frequenzen durch Störeinwirkungen am ausgekoppelten Meßsignal 32,34 bemerkbar machen würden.

Im Gegensatz zum Richtkoppler 56 ist die resistive Brücke 54 im unteren Frequenzbereich bei vergleichsweise tiefen Frequenzen zu betreiben. Für den Betrieb des Richtkopplers 56 bei tiefen Frequenzen wären vergleichsweise lange Kopplungsstrecken zur Auskopplung der niederfrequenten Signale notwendig. Derartige Kopplungsstrecken im Richtkoppler 56 der Meßbrücke 20,22 zu realisieren, würde besonders hohe Umsetzungskosten verursachen und die Ausmaße der Meßbrücke 20,22 erheblich vergrößern.

Die in Fig. 3 gezeigte Meßbrücke 20,22 unterscheidet sich von der in Fig. 2 gezeigten Meßbrücke 20,22 lediglich durch zwei zusätzliche Wechselschalter, einen zweiten meßobjektseitigen Wechselschalter 78 und einen zweiten meßkanalseitigen Wechselschalter 80. Der zweite meßobjektseitige Wechselschalter 78 ist, wie der erste meßobjektseitige Wechselschalter 72, hinsichtlich einer Laufrichtung 82 des rücklaufenden Signals 36,38 zweckmäßigerweise der Anordnung des Meßzweigs 64 des Richtkopplers 56 in unmittelbarer Nähe zur Meßleitung 8,10 nachgeschaltet.

Mittels des zweiten meßobjektseitigen Wechselschalters 78 und des zweiten meßkanalseitigen Wechselschalters ist ein Durchgangspfad 84 schaltbar, womit die Meßleitung 8,10 und der Meßkanal 40,42 der Meßbrücke 20,22 verbindbar sind. Somit ist eine Auskopplung des rücklaufenden Signal 36,38 über den als Koppelpfad ausgebildeten Meßzweig 64 des Richtkopplers 56 oder über den Übertrager 68 des Meßzweigs 66 der resistiven Brücke 54 nicht erforderlich. Das auf der Meßleitung 8,10 rücklaufende Signal 36,38 wird über den Durchgangspfad 84 leitungsgebunden dem Meßkanal 40,42 der Meßbrücke 20,22 als Meßsignal 32,34 zugeführt. Das Meßsignal 32,34 erfährt bei leitungsgebundener Zuführung durch den Durchgangspfad 84 lediglich eine vergleichsweise geringe Dämpfung durch den zweiten meßobjektseitigen Wechselschalter 78 und den zweiten meßkanalseitigen Wechselschalter 80. Eine vergleichsweise starke Dämpfung des Meßsignals 32,34 durch Auskopplung am Richtkoppler 56 oder an der resistiven Brücke 54 wird infolgedessen vermieden. Außerdem ist eine Weiterleitung des rücklaufenden Signals 36,38 als Meßsignal 32,34 über den Durchgangspfad 84 über den gesamten vom Signalgenerator 12 zu durchfahrenden (Sweep) Frequenzbereich ohne Einschränkungen durchführbar.

Die Weiterleitung des rücklaufenden Signals 36,38 durch den Durchgangspfad 84 eignet sich besonders für den Betrieb der Meßbrücke 20,22 als so genanntes Transmissionsmeßwerk. Die Meßbrücke 22, welche mit dem Ausgangstor 6 des Meßobjekts 2 über die Meßleitung 10 verbunden ist (Fig. 1), sei beispielsweise als Transmissionsmeßwerk betrieben und empfängt somit lediglich ein rücklaufendes Signal 38, also ein Anregungssignal 18, welches von dem Signalgenerator 12 erzeugt und über Meßbrücke 20 dem Meßobjekt 2 über dessen Eingangstor 4 zugeführt wird.

Ist die in Fig. 3 gezeigte Meßbrücke 20,22 im Gegensatz dazu als Reflexionsmeßwerk betrieben, so findet über die entsprechende Meßbrücke 20,22 sowohl die Weiterleitung des Anregungssignal 18 vom Signalgenerator 12 zum Meßobjekt 2 als auch die Auskopplung des am Meßobjekt 2 reflektierten, rücklaufenden Signals 36,38 statt. Bei einer als Reflexionsmeßwerk betriebenen Meßbrücke 20,22 wäre hier eine Umschaltung insbesondere des zweiten meßobjektseitigen Wechselschalters 78 nach der Zuführung des Anregungssignals zum Meßobjekt 2 und vor dem Empfang des rücklaufenden Signals 36,38 erforderlich. Eine derartige Umschaltung von als elektromechanische Schalter ausgebildeten Wechselschaltern 78,80 würde zu erheblichen Auswertungsverlusten des Meßsignals 32,34 führen.

Demzufolge ist der Durchgangspfad 84 insbesondere im Betrieb der Meßbrücke 20,22 als Transmissionsmeßwerk durch entsprechende Schalterstellung des zweiten meßobjektseitigen Wechselschalters 78 und des zweiten meßkanalseitigen Wechselschalters 80 aktiviert, wobei die Meßbrücke 20,22 lediglich das rücklaufende Signal 36,38, welches durch das Meßobjekt 2 transmittiert, weiterleitet und als Meßsignal 32,34 dem A/D-Wandler 46 zuführt. Würde die Meßbrücke 20,22 als Reflexionsmeßwerk betrieben, so ist der Durchgangspfad 84 grundsätzlich deaktiviert, damit das Anregungssignal 18 dem Eingangstor 4 oder dem Ausgangstor 6 des Meßobjekts 2 zur Verfügung gestellt und das rücklaufende Signal 36,38 an der Meßbrücke 20,22 einwandfrei ausgekoppelt werden kann.

Die Erfindung ist nicht auf die dargestellten Ausführungsbeispiele beschränkt und ist insbesondere auch bei anders als in Fig. 1 ausgestalteten Netzwerkanalyatoren, insbesondere auch mit mehr als zwei Meßtoren, geeignet. Alle vorstehend beschriebenen oder in der Zeichnung dargestellten Merkmale sind beliebig miteinander kombinierbar.

## Patentansprüche

1. Netzwerkanalysator (1) mit einem Signalgenerator (12) zum Erzeugen eines Anregungssignals (18), welches über eine Messleitung (8, 10) einem am Netzwerkanalysator (1) anschliessbaren Messobjekt (2) zuführbar ist, und einer mit der Messleitung (8, 10) signalverbundenen Messbrücke (20, 22), worüber ein dem Anregungssignal (18) entsprechendes Referenzsignal (24, 26) auf einen Referenzkanal (28, 30) und ein einem vom Messobjekt (2) rücklaufenden Signal (36, 38) entsprechendes Messsignal (32, 34) auf einen Messkanal (40, 42) auskoppelbar sind, wobei die Messbrücke (20, 22) zumindest eine resistive Brücke (54) und zumindest einen Richtkoppler (56) derart aufweist, dass die Messbrücke (20, 22) in einem unteren Frequenzbereich als resistive Brücke (54) und in einem oberen Frequenzbereich als Richtkoppler (56) betrieben ist, wobei die resistive Brücke (54) zum Richtkoppler (56) derart angeordnet ist,
dass an der Messleitung (8, 10) ein erster messobjektseitiger Wechselschalter (72) vorgesehen ist, um im Betrieb als resistive Meßbrücke die resistive Brücke (54) mit der Messleitung (8, 10) zu verbinden und im Betrieb als Richtkoppler derart geschaltet ist, dass das auf der Messleitung (8, 10) vorlaufende Anregungssignal (18) einen Durchgangszweig (76) des Richtkopplers (56) passiert und das rücklaufende Signal (36, 38) über einen Messzweig (66) der resistiven Brücke (54) bzw. einen Messzweig (64) des Richtkopplers (56) als Messsignal (32, 34) ausgekoppelt ist,
dass der als Koppelpfad ausgebildete Messzweig (64) des Richtkopplers (56) hinsichtlich einer Laufrichtung (82) des in der Messleitung (8, 10) rücklaufenden Signals (36, 38) dem ersten messobjektseitigen Wechselschalter (72) vorgeschaltet ist, **dadurch gekennzeichnet, dass** an der Messbrücke (20, 22) weitere Wechselschalter (70, 74) vorgesehen sind, um zusammen mit dem ersten messobjektseitigen Wechselschalter (72) vom Betrieb der Messbrücke (20, 22) als resistive Brücke (54) in den Betrieb der Messbrücke (20, 22) als Richtkoppler (56) umzuschalten.

2. Netzwerkanalysator nach Anspruch 1,
**dadurch gekennzeichnet,**
**dass** an der Messleitung (8, 10) ein signalgeneratorseitiger Wechselschalter (70) vorgesehen ist, um das Anregungssignal (18) entweder der resistiven Brücke (54) oder dem Richtkoppler (56) zur Verfügung zu stellen und das Referenzsignal (24, 26) entweder über einen Referenzzweig (58) der resistiven Brücke (54) oder über einen Referenzzweig (60) des Richtkopplers (56) auszukoppeln und dem Referenzkanal (28, 30) der Messbrücke (20, 22) zuzuführen.

3. Netzwerkanalysator nach Anspruch 2,
**dadurch gekennzeichnet,**
**dass** der Referenzzweig (58) der resistiven Brücke (54) und der Referenzzweig (60) des Richtkopplers (56) schaltungstechnisch zumindest teilweise in einer Einheit verbunden sind.

4. Netzwerkanalysator nach einem der Ansprüche 1 bis 3,
**dadurch gekennzeichnet,**
**dass** am Messkanal (40, 42) der Messbrücke (20, 22) ein erster messkanalseitiger Wechselschalter (74) vorgesehen ist, um das über den Messzweig (64) des Richtkopplers (56) bzw. über den Messzweig (66) der resistiven Brücke (54) ausgekoppelte Messsignal (32, 34) dem Messkanal (40, 42) der Messbrücke (20, 22) zuzuführen.

5. Netzwerkanalysator nach einem der Ansprüche 1 bis 4,
**dadurch gekennzeichnet,**
**dass** mittels eines zweiten messobjektseitigen Wechselschalters (78) die Messleitung (8, 10) mit dem Messkanal (40, 42) der Messbrücke (20, 22) zur Ausbildung eines Durchgangspfades (84) leitungsverbindbar ist.

6. Netzwerkanalysator nach Anspruch 5,
**dadurch gekennzeichnet,**
**dass** der zweite messobjektseitige Wechselschalter (78) hinsichtlich der Laufrichtung (82) des in der Messleitung (8, 10) rücklaufenden Signals (36, 38) zumindest dem als Koppelpfad ausgebildeten Messzweig (64) des Richtkopplers (56) nachgeschaltet ist.

7. Netzwerkanalysator nach Anspruch 5 oder 6,
**dadurch gekennzeichnet,**
**dass** am Messkanal (40, 42) der Messbrücke (20, 22) ein zweiter messkanalseitiger Wechselschalter (80) vorgesehen ist, um das Messsignal (32, 34) entweder über den Messzweig (64) des Richtkopplers (56) bzw. über den Messzweig (66) der resistiven Brücke (54) auszukoppeln und dem Messkanal (40, 42) der Messbrücke (20, 22) zuzuführen oder über den mit der Messleitung (8, 10) leitungsverbundenen Durchgangspfad (84) dem Messkanal (40, 42) der Messbrücke (20, 22) leitungsgebunden zuzuführen.

8. Netzwerkanalysator nach einem der Ansprüche 1 bis 7,
**dadurch gekennzeichnet,**
**dass** der bzw. die Wechselschalter (70, 72, 74, 78, 80) als elektromechanischer bzw. elektromechanische Schalter ausgebildet.

## Claims

1. Network analyser (1) with a signal generator (12) for generating an excitation signal (18) which can be fed via a measuring line (8, 10) to a measurement object (2) which can be connected to the network analyser (1), and a measuring bridge (20, 22) connected by signals with the measuring line (8, 10), via which a reference signal (24, 26) corresponding to the excitation signal (18) can be decoupled onto a reference channel (28, 30) and a measurement signal (32, 34) corresponding to a signal (36, 38) returning from the measurement object (2) can be decoupled onto a measuring channel (40, 42),
wherein the measuring bridge (20, 22) has at least one resistive bridge (54) and at least one directional coupler (56) such that the measuring bridge (20, 22) is operated in a lower frequency range as a resistive bridge (54) and in an upper frequency range as a directional coupler (56),
wherein the resistive bridge (54) is arranged in relation to the directional coupler (56) in such a way that a first changeover switch (72) on the measurement object side is provided on the measuring line (8, 10) in order when in operation as a resistive measuring bridge to connect the resistive bridge (54) with the measuring line (8, 10), and when in operation as a directional coupler is switched in such a way that the excitation signal (18) travelling on the measuring line (8, 10) passes through a connecting branch (76) of the directional coupler (56) and the returning signal (36, 38) is decoupled via a measuring branch (66) of the resistive bridge (54) or a measuring branch (64) of the directional coupler (56) as a measurement signal (32, 34),
that the measuring branch (64) of the directional coupler (56) embodied in the form of a coupling path is connected in front of the first changeover switch (72) on the measurement object side with respect to a direction of travel (82) of the signal (36, 38) returning in the measuring line (8, 10),
**characterised in that** further changeover switches (70, 74) are provided on the measuring bridge (20, 22) in order to switch over together with the first changeover switch (72) on the measurement object side from operation of the measuring bridge (20, 22) as a resistive bridge (54) to operation of the measuring bridge (20, 22) as a directional coupler (56).

2. Network analyser according to claim 1,
**characterised in that**
a changeover switch (70) on the signal generator side is provided on the measuring line (8, 10) in order to make the excitation signal (18) available either to the resistive bridge (54) or to the directional coupler (56) and to decouple the reference signal (24, 26) either via a reference branch (58) of the resistive bridge (54) or via a reference branch (60) of the directional coupler (56) and feed it to the reference channel (28, 30) of the measuring bridge (20, 22).

3. Network analyser according to claim 2,
**characterised in that**
the reference branch (58) of the resistive bridge (54) and the reference branch (60) of the directional coupler (56) are at least partially combined in circuit terms in a unit.

4. Network analyser according to one of claims 1 to 3,
**characterised in that**
a first changeover switch (74) on the measuring channel side is provided on the measuring channel (40, 42) of the measuring bridge (20, 22) in order to feed the measurement signal (32, 34) decoupled via the measuring branch (64) of the directional coupler (56) or via the measuring branch (66) of the resistive bridge (54) to the measuring channel (40, 42) of the measuring bridge (20, 22).

5. Network analyser according to one of claims 1 to 4,
**characterised in that**
the measuring line (8, 10) can be connected in line terms with the measuring channel (40, 42) of the measuring bridge (20, 22) by means of a second changeover switch (78) on the measurement object side to form a connecting path (84).

6. Network analyser according to claim 5,
**characterised in that**
the second changeover switch (78) on the measurement object side is connected after at least the measuring branch (64) of the directional coupler (56) embodied as a coupling path with respect to the direction of travel (82) of the signal (36, 38) returning in the measuring line (8, 10).

7. Network analyser according to claim 5 or 6,
**characterised in that**
a second changeover switch (80) on the measuring channel side is provided on the measuring channel (40, 42) of the measuring bridge (20, 22) in order to decouple the measurement signal (32, 34) either via the measuring branch (64) of the directional coupler (56) or via the measuring branch (66) of the resistive bridge (54) and feed it to the measuring channel (40, 42) of the measuring bridge (20, 22) or to feed it in line-conducted manner to the measuring channel (40, 42) of the measuring bridge (20, 22) via the connecting path (84) connected by line with the measuring line (8, 10).

8. Network analyser according to one of claims 1 to 7,
**characterised in that**
the changeover switch or switches (70, 72, 74, 78, 80) is/are embodied in the form of an electro-mechanical switch or switches.

## Revendications

1. Analyseur de réseau (1) comprenant un générateur de signal (12) destiné à produire un signal d'excitation (18) qui peut être amené, par l'intermédiaire d'un conducteur de mesure (8, 10) à un objet de mesure (2) pouvant être raccordé à l'analyseur de réseau (1), et un pont de mesure (20, 22) relié sur le plan de la transmission de signal au conducteur de mesure (8, 10), par l'intermédiaire duquel un signal de référence (24, 26) correspondant au signal d'excitation (18) peut être découplé vers un canal de référence (28, 30), et un signal de mesure (32, 34) correspondant à un signal de retour (36, 38) de l'objet de mesure (2), peut être découplé vers un canal de mesure (40, 42),
analyseur
dans lequel le pont de mesure (20, 22) présente au moins un pont résistif (54) et au moins un coupleur directionnel (56) de manière telle, que le pont de mesure (20, 22) fonctionne, dans une plage inférieure de fréquences en tant que pont résistif (54), et dans une plage supérieure de fréquences en tant que coupleur directionnel (56),
dans lequel le pont résistif (54) est agencé de manière telle par rapport au coupleur directionnel (56), que dans le conducteur de mesure (8, 10) soit prévu un premier commutateur d'inversion (72) du côté objet de mesure, pour, lors du fonctionnement en tant que pont de mesure résistif, relier le pont résistif (54) au conducteur de signal (8, 10), et, lors du fonctionnement en tant que coupleur directionnel, être commuté de manière telle, que le signal d'excitation (18) circulant à l'aller sur le conducteur de mesure (8, 10) passe une branche passante (76) du coupleur directionnel (56) et le signal de retour (36, 38) soit découplé en tant que signal de mesure (32, 34), par l'intermédiaire d'une branche de mesure (66) du pont résistif (54), respectivement une branche de mesure (64) du coupleur directionnel (56),
et dans lequel la branche de mesure (64) réalisée en tant que chemin de couplage du coupleur directionnel (56) est, en se référant à un sens de circulation (82) du signal de retour (36, 38) dans le conducteur de mesure (8, 10), montée en amont du premier commutateur d'inversion (72) du côté objet de mesure,
**caractérisé**
**en ce que** dans le pont de mesure (20, 22) sont prévus d'autres commutateurs d'inversion (70, 74), pour, en commun avec le premier commutateur d'inversion (72) du côté objet de mesure, commuter du fonctionnement du pont de mesure (20, 22) en tant que pont résistif (54), au fonctionnement du pont de mesure (20, 22) en tant que coupleur directionnel (56).

2. Analyseur de réseau selon la revendication 1,
**caractérisé**
**en ce que** dans le conducteur de mesure (8, 10) il est prévu un commutateur d'inversion (70) du côté générateur de signal, pour fournir le signal d'excitation (18) soit au pont résistif (54) soit au couleur directionnel (56), et découpler le signal de référence (24, 26), soit par l'intermédiaire d'une branche de référence (58) du pont résistif (54), soit par l'intermédiaire d'une branche de référence (60) du coupleur directionnel (56), et l'amener au canal de référence (28, 30) du pont de mesure (20, 22).

3. Analyseur de réseau selon la revendication 2,
**caractérisé**
**en ce que** la branche de référence (58) du pont résistif (54) et la branche de référence (60) du coupleur directionnel (56) sont reliées au moins en partie, sur le plan de la technique des circuits, dans une unité.

4. Analyseur de réseau selon l'une des revendications 1 à 3,
**caractérisé**
**en ce que** dans le canal de mesure (40, 42) du pont de mesure (20, 22), il est prévu un premier commutateur d'inversion (74) du côté canal de mesure, pour amener le signal de mesure (32, 34) découplé par l'intermédiaire de la branche de mesure (64) du coupleur directionnel (56) ou respectivement par l'intermédiaire de la branche de mesure (66) du pont résistif (54), au canal de mesure (40, 42) du pont de mesure (20, 22).

5. Analyseur de réseau selon l'une des revendications 1 à 4,
**caractérisé**
**en ce qu'**au moyen d'un deuxième commutateur d'inversion (78) du côté objet de mesure, le conducteur de mesure (8, 10) peut être relié sur le plan conducteur, au canal de mesure (40, 42) du pont de mesure (20, 22) en vue de former un chemin passant (84).

6. Analyseur de réseau selon la revendication 5,
**caractérisé**
**en ce que** le deuxième commutateur d'inversion (78) du côté objet de mesure est monté en aval au moins de la branche de mesure (64) du coupleur directionnel (56) réalisée en tant que chemin de couplage, en se référant à la direction de circulation (82) du signal de retour (36, 38) circulant dans le conducteur de mesure (8, 10).

7. Analyseur de réseau selon la revendication 5 ou la revendication 6,
**caractérisé**
**en ce que** dans le canal de mesure (40, 42) du pont de mesure (20, 22) il est prévu un deuxième commutateur d'inversion (80) du côté canal de mesure, pour, soit découpler le signal de mesure (32, 34) par l'intermédiaire de la branche de mesure (64) du coupleur directionnel (56) ou respectivement par l'intermédiaire de la branche de mesure (66) du pont résistif (54), et l'amener au canal de mesure (40, 42) du pont de mesure (20, 22), soit l'amener au canal de mesure (40, 42) du pont de mesure (20, 22), de manière liée au conducteur, par l'intermédiaire du chemin passant (84) relié sur le plan conducteur au conducteur de mesure (8, 10).

8. Analyseur de réseau selon l'une des revendications 1 à 7,
**caractérisé**
**en ce que** le commutateur ou les commutateurs d'inversion (70, 72, 74, 78, 80) est ou sont réalisés en tant que commutateur ou commutateurs électromécanique(s).
